(19) Europäisches Patentamt
European Patent Office
Office européen des brevets

(11) EP 1 369 926 A2

(12) **EUROPEAN PATENT APPLICATION**

(43) Date of publication:
**10.12.2003 Bulletin 2003/50**

(51) Int Cl.⁷: **H01L 29/423**, H01L 29/78, H01L 21/8246

(21) Application number: **03253199.8**

(22) Date of filing: **22.05.2003**

(84) Designated Contracting States:
**AT BE BG CH CY CZ DE DK EE ES FI FR GB GR HU IE IT LI LU MC NL PT RO SE SI SK TR**
Designated Extension States:
**AL LT LV MK**

(30) Priority: **04.06.2002 US 164785**

(71) Applicant: **SHARP KABUSHIKI KAISHA**
**Osaka 545-8522 (JP)**

(72) Inventors:
• **Hsu, Sheng Teng**
**Camas, WA 98607 (US)**
• **Zhang, Fengyan**
**Vancouver, WA 98683 (US)**
• **Li, Tingkai**
**Vancouver, WA 98683 (US)**

(74) Representative: **Brown, Kenneth Richard et al**
**R.G.C. Jenkins & Co.**
**26 Caxton Street**
**London SW1H 0RJ (GB)**

(54) **Ferroelectric memory transistor and method for forming the same**

(57)     An object of the present invention is to provide a non-volatile ferroelectric memory device, which eliminates leakage-related transistor memory retention degradation. A ferroelectric memory transistor according to the present invention comprises: a substrate having a source region (54), a gate region (58), and a drain region (56); a gate stack (60) located on the gate region, including: a high-k insulator element (62), including a first high-k cup (62L) and a second high-k cup (62U); a ferroelectric element (64), wherein said ferroelectric element is encapsulated within said high-k insulator element (62); and a top electrode (66) located on a top portion of said high-k insulator element; a passivation oxide layer (68) located over the substrate and gate stack; and metalizations (70,74,72) to form respective contacts to the source region, the drain region and the gate stack.

*FIG.4*

**Description**

BACKGROUND OF THE INVENTION

1. FIELD OF THE INVENTION:

This invention relates to the fabrication of a long-memory-retention-time single transistor ferroelectric RAM, and specifically to a ferroelectric RAM having a ferroelectric element which is encapsulated in a high-k dielectric.

2. DESCRIPTION OF THE RELATED ART:

Prior art single transistor metal-ferroelectric-oxide semiconductor (MFOS) gate stacks include a top electrode, a ferroelectric layer and an oxide layer. After such a device is programmed, electrons, or holes, may flow from the top electrode into and become trapped in the ferroelectric layer. The polarity of the trapped charge is opposite to that of the polarization charges. These trapped charges compensate for the polarization charges, causing the reduction of the memory window. As a result, transistor memory retention is degraded.

It is an object of the invention to provide a non-volatile ferroelectric memory device, which eliminates the leakage-related transistor memory retention degradation.

Another object of the invention is to provide a ferroelectric memory cell including the ferroelectric element encapsulated in a high-k dielectric.

SUMMARY OF THE INVENTION

A ferroelectric memory transistor according to the present invention comprises: a substrate having a source region, a gate region, and a drain region; a gate stack located on the gate region, including: a high-k insulator element, including a first high-k cup and a second high-k cup; a ferroelectric element, wherein said ferroelectric element is encapsulated within said high-k insulator element; and a top electrode located on a top portion of said high-k insulator element; a passivation oxide layer located over the substrate and gate stack; and metalizations to form respective contacts to the source region, the drain regions and the gate stack, thereby achieving the above-described objects.

Said high-k insulator element may be formed of a material taken from the group of materials consisting of $HfO_2$ $ZrO_2$ and $HfZrO_x$.

Said high-k insulator element may have a thickness of between about 2 nm to 10 nm.

Said ferroelectric element may be formed of a material taken from the group of materials consisting of PGO, PZT, BTO, SBTO, and SBTN.

Said ferroelectric element may have a thickness of between about 100 nm to 600 nm.

Said top electrode may be formed of a material taken from the group of materials consisting of copper, aluminum, iridium and platinum.

A method of forming a ferroelectric memory transistor according to the present invention comprises: a) preparing a substrate, including forming a source region, a gate region, a drain region and an oxide device isolation region; b) depositing a sacrificial oxide layer on the substrate; c) depositing a gate placeholder layer on the sacrificial oxide layer; d) masking the gate placeholder layer and the sacrificial oxide layer located on the gate region and removing the gate placeholder layer and the sacrificial oxide layer on the source region, the drain region and the oxide device isolation region; e) depositing a layer of oxide over the structure obtained by steps a) through d) to a thickness of approximately twice that of the gate placeholder layer; f) smoothing the structure obtained by steps a) through e) to the level of the gate placeholder layer; g) removing the gate placeholder layer and the sacrificial oxide layer in the gate region, forming a gate placeholder structure; h) depositing a high-k insulator layer over the structure obtained by steps a) through g) to form a first high-k cup; i) filling the first high-k cup with a ferroelectric material to form a ferroelectric element; j) smoothing the ferroelectric element to the upper level of the oxide layer; k) depositing a further high-k insulator layer on the structure obtained by steps a) through j) to form a second high-k cup over the ferroelectric element; l) depositing a top electrode over the second high-k cup to form a gate electrode and gate stack; m) depositing a layer of passivation oxide over the structure obtained by steps a) through l); n) etching the passivation oxide to form respective contact vias to the source region, the drain region and the gate stack; and o) metallizing the structure obtained by steps a) through n), thereby achieving the above-described objects.

Said step g) of depositing a high-k insulating layer and depositing a first high-k cup may include selecting a high-k insulator material from the group of materials consisting of $HfO_2$, $ZrO_2$ and HfZrOX.

Said step g) of depositing a high-k insulating layer and depositing a first high-k cup include depositing a layer of high-k materials to a thickness of between about 2 nm to 10 nm.

Said step h) of filling the first high-k cup with a ferroelectric material may include selecting a ferroelectric material from the group of materials consisting of PGO, PZT, BTO, SBTO, and SBTN.

Said step h) of filling the first high-k cup with a ferroelectric material may include filling the first high-k cup with ferroelectric material to a thickness of between about 100 nm to 600 nm.

Said step k) of depositing a top electrode over the second high-k cup to form a gate electrode and gate stack may include selecting a top electrode material from the group of materials consisting of copper, aluminum, iridium and platinum.

Said step c) of depositing a gate placeholder layer may include depositing a layer of material taken from the group of materials consisting of silicon nitride and polysilicon.

This summary and objectives of the invention are provided to enable quick comprehension of the nature of the invention. A more thorough understanding of the invention may be obtained by reference to the following detailed description of the preferred embodiment of the invention in connection with the drawings.

BRIEF DESCRIPTION OF THE DRAWINGS

Fig. 1 is a schematic diagram of a prior art transistor 10.

Fig. 2 depicts the charge and field distribution during memory retention after the ferroelectric capacitor of Fig. 1 is programmed to the low threshold voltage state and the gate is at the ground potential.

Fig. 3a is a schematic diagram for explaining charge trapping.

Fig. 3b is another schematic diagram for explaining charge trapping.

Fig. 4 is a schematic diagram of a ferroelectric memory transistor 50 according to the present invention.

Fig. 5 depicts a state of a ferroelectric memory transistor according to the present invention.

Figs. 6-10 depict successive steps in the fabrication method of the ferroelectric memory transistor according to the present invention.

DESCRIPTION OF THE PREFERRED EMBODIMENTS

Related Application

This application is related to *MFOS memory transistor and method of fabricating same*, of Hsu *et al.*, Serial No. 09/820,039, filed March 28, 2001.

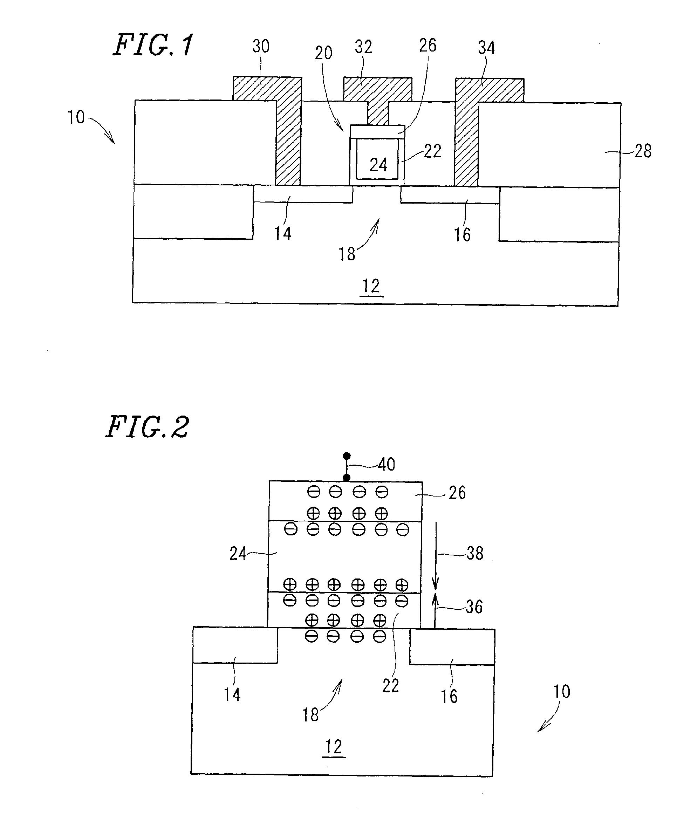

Fig. 1 is a schematic diagram of a prior art transistor 10. For example, the prior art transistor 10 is a typical state-of-the-art transistor such as a metal-ferroelectric-oxide semiconductor (MFOS) transistor, metal-ferroelectric-insulatorsemiconductor (MFIS) transistor, or the like.

Transistor 10 includes a substrate 12 having a source region 14, a drain region 16 and a gate region 18, and a gate stack 20 on the gate region 18.

The gate stack 20 includes a high-k insulator 22, a ferroelectric element 24 and a top electrode 26.

High-k insulator 22, in the prior art is located below and around the sides of the ferroelectric element 24. The structure is covered with a passivation oxide 28, which has vias formed therein for the provision of metal contacts 30, 32 and 34, for, respectively, source region 14, gate stack 20 and drain region 16.

Gate stack 20 includes a metal-ferroelectric thin film-insulator on a silicon substrate (MFIS). High-k insulator 22 has a high dielectric constant and low leakage current, and may be selected from materials such as $HfO_2$, $ZrO_2$. or $HfZrO_x$. The ferroelectric element 24 is taken from the group of materials consisting of lead germanium oxide $(Pb_5Ge_3O_{11})$ (PGO), $Pb(Zr,Ti)O_3$ (PZT), Sr $Bi_2Ta_2O_9$ (BTO), $SrBa_2Ta_2O_9$ (SBTO), and $SrBi_2 (Ta_1xNb_x)_2O_9$ (SBTN), and the top electrode may be formed of copper, aluminum, iridium or platinum. Such a structure is referred to as a ferroelectric capacitor.

Fig. 2 depicts the charge and field distribution during memory retention after the ferroelectric capacitor of Fig. 1 is programmed to the low threshold voltage state and the gate is at the ground potential. Arrow 36 represents the voltage of the high-k insulator 22 , $V_{ox}$, arrow 38 represents the voltage of the ferroelectric (FE) element 24, $V_{FE}$, and 40 represents the voltage at the top of the gate stack 20, $V_0$. There is a voltage across the high-k insulator 22 as well as across the ferroelectric element 24. The voltage across the high-k insulator 22 is equal to but of opposite polarity as that of the voltage across the ferroelectric element 24. The voltage in the ferroelectric element 24 is referred to as the de-polarization voltage.

$$V_{FE} = V_{OX} - V_{00} \qquad (1)$$

$$V_{00} = Q_R/(C_{OX} + C_{FE}) \qquad (2)$$

where QR is the charge on the ferroelectric element 24, $C_{ox}$ is the capacitance of the high-k insulator 22 and $C_{FE}$ is the capacitance of the ferroelectric element 24.

Although it is not possible for holes, or electrons, to flow from high-k insulator 22 into ferroelectric element (ferroelectric thin film) 24, there are a large number of electrons and holes in the top electrode 26. Next, a phenomenon where holes from the top electrode 26 are trapped in the ferroelectric element 24 will be described.

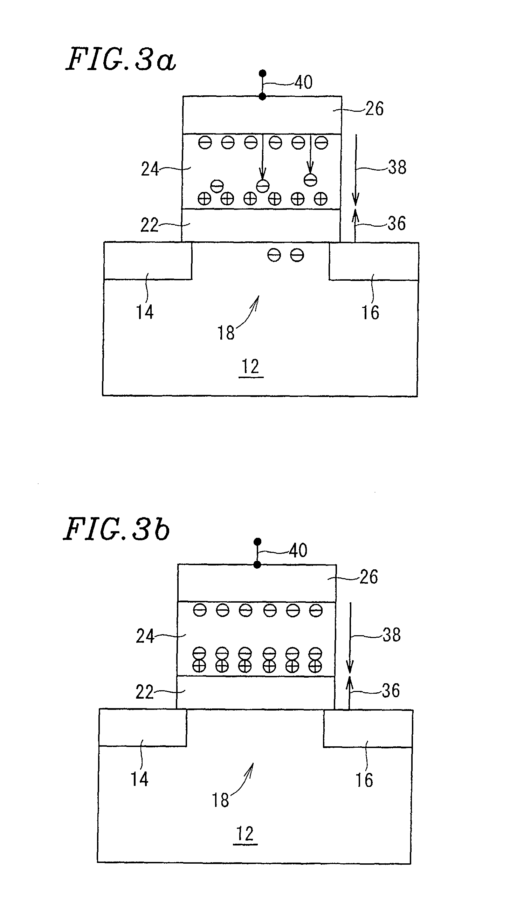

Fig. 3a is a schematic diagram for explaining charge trapping. Holes may move from top electrode 26 into ferroelectric element 24, as shown in Fig. 3a. This phenomenon is referred to as the leakage current of a metal-ferroelectric-metal (MFM) capacitor. Holes cannot flow through the high-k insulator 22 because of the potential barrier at the high-k insulator 22 and ferroelectric element 24 interface and the opposite polarity of electric field in the high-k insulator 22 from that of electric field in the ferroelectric element 24.

Fig. 3b is another schematic diagram for explaining charge trapping. The holes which cannot flow from the ferroelectric element 24 to the high-k insulator 22 move into the ferroelectric material, as described with reference to Fig. 3a, will remain trapped in the ferroelectric element 24, as illustrate in Fig. 3b, where $V_{FE}$ and $V_{ox}$ both equal zero. The trapped holes in the ferroelectric element 24 compensate for the polarized electrons in the ferroelectric element 24. This reduces the memory window of the memory transistor and degrades the memory characteristic of the device. When the memory transistor has been programmed to its high threshold voltage state, the charge and the voltage polarities change, however, the flow of electrons and the trapping mechanisms are as described above.

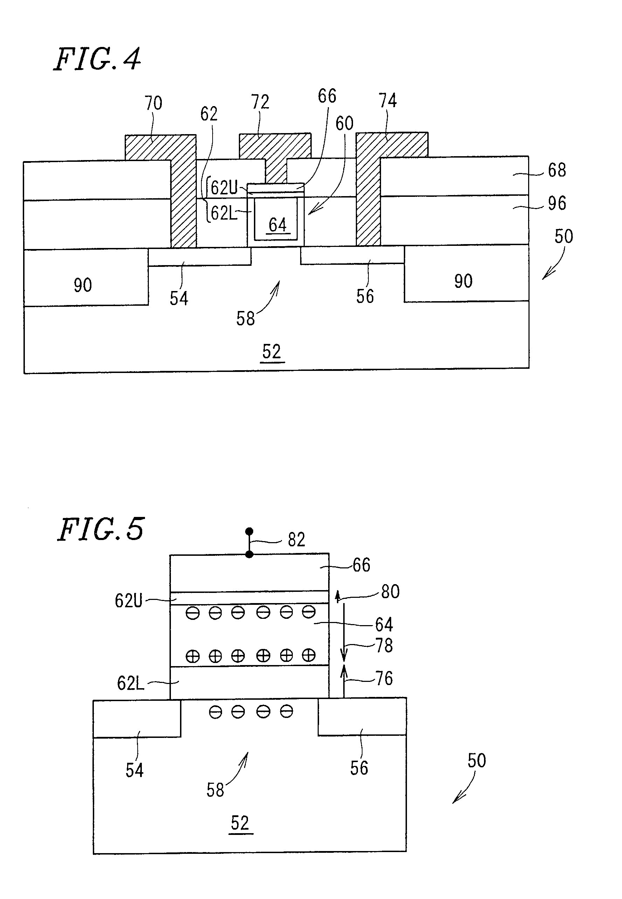

Fig. 4 is a schematic diagram of a ferroelectric memory transistor 50 according to the present invention. In the ferroelectric memory transistor 50 according to the present invention, to eliminate this leakage current related memory retention degradation described with reference to Figs 1-3, an additional insulator is used in between the ferroelectric thin film and the top electrode.

Transistor 50 includes a substrate 52 having a source region 54, a drain region 56 and a gate 58, and a gate stack 60. The gate stack 60 includes a high-k insulator 62 which encapsulates a ferroelectric element 64, and a top electrode 66. The substrate 52 has an oxide isolation region (oxide element isolation region) 90.

High-k insulator 62 includes a first high-k cup (or, simply referred as a lower portion), 62L, which is located between the ferroelectric element 64 and silicon substrate 52, and which encloses the sides of the ferroelectric element 64, and a second high-k cup (or, simply referred as an upper portion) , 62U, which is located between ferroelectric element 64 and top electrode 66. Thus, the ferroelectric element 64 is encapsulated in the high-k insulator 62 (the first high-k cup 62L and the second high-k cup 62U). The structure is covered with a silicon oxide layer 96 and a passivation oxide 68, which has vias formed therein for the provision of metal contact 70, 72 and 76, for, respectively, source region 54, gate stack 60 and drain region 56. Gate stack 60 includes a metal-ferroelectric thin film-insulator on a silicon substrate (MFIS).

High-k insulator 62 has a high dielectric constant and low leakage current, and may be selected from the group of materials consisting of $HfO_2$, $ZrO_2$, and $HfZrO_X$. The ferroelectric element 64 is taken from the group of materials consisting of lead germanium oxide ($Pb_5Ge_3O_{11}$) (PGO), $Pb(Zr,Ti)O_3$ (PZT), Sr $Bi_2Ta_2O_9$ (BTO), $SrBa_2Ta_2O_9$ (SBTO), and $SrBi_2(Ta_{1-x}Nb_x)_2O_9$ (SBTN), and the top electrode may be formed of a material from the group consisting of copper, aluminum, iridium and platinum.

Fig. 5 depicts the state of a ferroelectric memory transistor according to the present invention. Specifically, Fig. 5 illustrates the field polarity and the charge distribution, after programming the ferroelectric memory transistor to its low threshold voltage, and after the gate voltage returns to ground potential. The voltage across the ferroelectric element 64,78 ($V_{FE}$), is equal to the sum of voltage across the first high-k cup 62L (arrow 76, $V_{ox1}$) and the second high-k cup 62U (arrow 80, $V_{ox2}$). The polarity of the electric field in the ferroelectric element 64 is opposite to that in the first and second high-k cups 62L and 62U. The usual leakage current related degradation mechanisms found in the prior art do not exist in this structure because there are no free carriers in the two insulators (the first and the second high-k cups 62L and 62U) and because the field distribution current carriers are prevented from flowing into the ferroelectric element 64. Arrow 82 represents the voltage at the top of top electrode 66, V0. The only source of memory degradation in the structure of the invention is due to the de-polarization field.

When the ferroelectric memory transistor of the invention is programmed to its high threshold voltage state, the electric charge and the electric field polarities in both ferroelectric element 64 and the first and the second high-k cups 62L and 62U change directions. There is no leakage-related charge trapping, which may cause memory retention degradation.

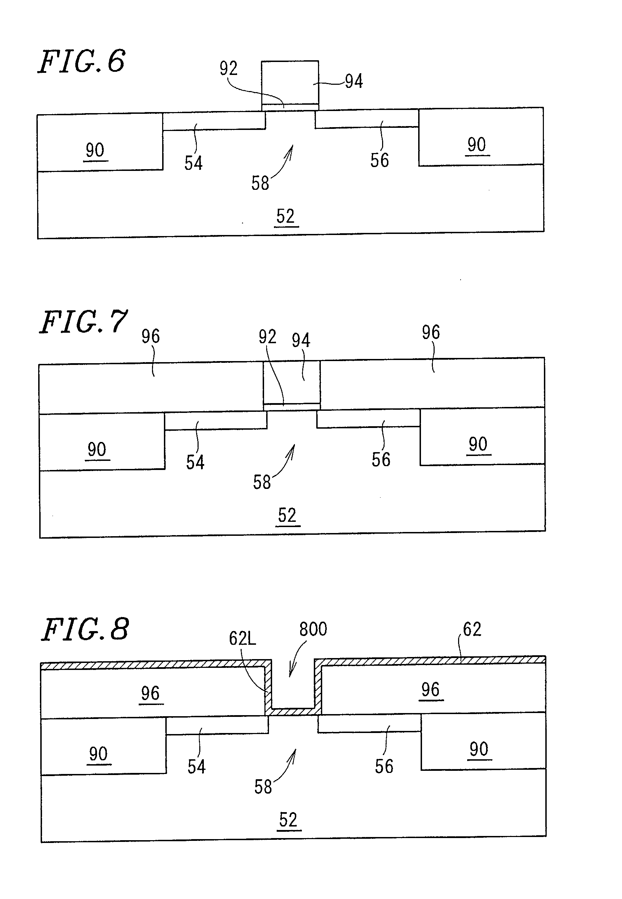

A fabrication method of the ferroelectric memory transistor according to the present invention will be described with reference to Figs 6-10.

Fig. 6 depicts a step in the fabrication method of the ferroelectric memory transistor according to the present invention. The substrate 52 is prepared by any state-of-the-art technique for substrate preparation. Well ion implantation forms active regions including the source region 54 and the drain region 56, and a gate region 58 in the substrate 52. The device isolation method includes a step of forming the oxide isolation region 90, which extends about the periphery of the memory transistor.

Then, a sacrificial gate oxide layer (sacrificial oxide layer) 92 is grown to a thickness of between about 2 nm to 5 nm on the source region 54, the drain region 56, the gate region 58, and the oxide isolation region 90, and a layer of silicon nitride 94 is deposited to a thickness of between about 100 nm to 600 nm on the sacrificial gate oxide layer 92 . The siliconnitride layer 94 and the sacrificial gate oxide layer 92 on the gate region 58 are masked, and the silicon nitride layer 94 and the sacrificial gate oxide layer 92 on the source region 54, the drain region 56, the gate region 58, and the oxide isolation region 90 are removed. Thus, the gate placeholder consisting of the nitride silicon layer 94 remains on the gate region 58. Polysilicon may be used in place of the silicon nitride layer.

In Fig. 6, the sacrificial gate oxide layer 92 on the source region 54, the drain region 56, and the oxide isolation region 90 is removed. However, the sacrificial gate oxide layer 92 may not be removed and used with the silicon oxide layer 96 instead.

Active regions (source region 54 and drain region 56) may be prepared by source/drain implantation, including LDD, Halo, and N+ or P+ ion implantation if so desired at this time. Thus, the structure depicted in Fig. 6 is obtained.

Fig. 7 depicts a step in the fabrication method of the ferroelectric memory transistor according to the present invention. The silicon oxide layer 96 is deposited to a thickness of between about 200 nm to 1200 nm. The thickness of this silicon oxide layer 96 is preferred to be about two times as thick as that of the gate placeholder. The structure is smoothed by CMP to planarize the silicon oxide layer 96 , stopping at the level of the silicon nitride layer 94 (or, gate placeholder). Thus, the structure depicted in Fig. 7 is obtained.

Fig. 8 depicts a step in the fabrication method of the ferroelectric memory transistor according to the present invention. As depicted in Fig. 8, the structure is etched, and the silicon nitride layer 94 (gate placeholder layer) is removed to form a gate placeholder structure 800. The silicon nitride layer 94 (gate placeholder layer) is etched preferably by a wet etch process. Next, the entire structure is etched by BHF to remove the sacrificial gate oxide layer 92 in the gate region 58.

Then, a gate insulator 62 is deposited on the entire structure. As described above, the gate insulator 62 is selected from a group of materials consisting of $HfO_2$, $ZrO_2$, and $HfZrO_X$. The gate insulator 62 is formed of a high-k insulator, previously described and identified, having a thickness of between about 2 nm to 10 nm. The portion of the gate insulator 62 in contact with the silicon substrate 52 which corresponds to the gate region 58, and which covers the walls of the gate placeholder structure 800, is designated as 62L. The portion 62L is referred to herein as a first high-k cup, or high-k lower portion.

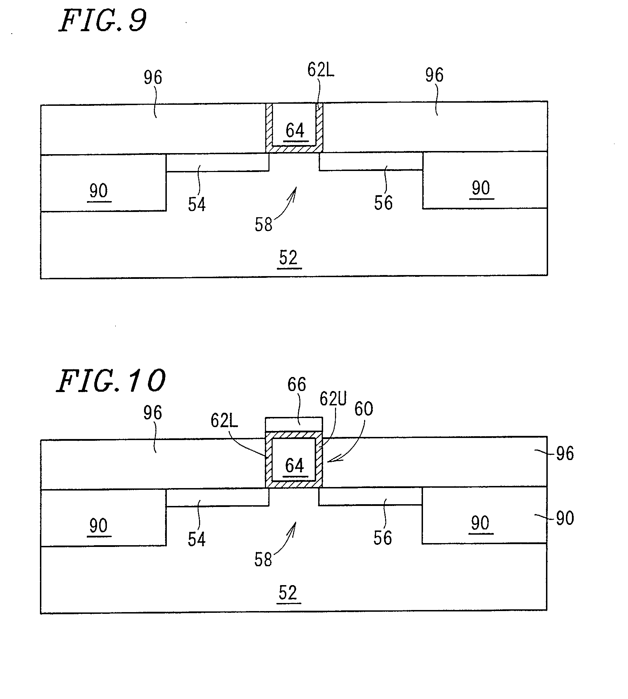

Fig. 9 depicts a step in the fabrication method of the ferroelectric memory transistor according to the present invention. A ferroelectric thin film (ferroelectric element) 64 is deposited to fill the gate placeholder 800. The ferroelectric thin film 64 is selected from a group of materials such as PGO, PZT, BTO, SBTO, and SBTN. The ferroelectric thin film 64 fills the "cup" formed by the first high-k cup 62L.

Next, the ferroelectric thin film 64 is smoothed, stopping at the level of silicon oxide layer 96. The smoothing may be accomplished by chemical mechanical polishing (CMP) or by any well-known planar etchback process. Thus, the structure depicted in Fig. 9 is obtained.

Fig. 10 depicts a step in the fabrication method of the ferroelectric memory transistor according to the present invention. Then, a further high-k insulator which is to be another portion of the high-k insulator, 62U, referred to herein as a high-k upper portion or second high-k cup, is deposited by CVD to a thickness of between about 2 nm to 10 nm on the structure depicted in Fig 9. The selected further high-k insulator material has low leakage current properties. Thereafter, the top electrode 66 is formed on the further high-k insulator. The top electrode is selected from the group of materials consisting of aluminum, copper, platinum and iridium.

The top electrode and the further high-k insulator are etched to form the top electrode 66 and the second high-k cup 62U depicted in Fig. 10, resulting in a control gate electrode and gate stack 60. The ferroelectric element 64 is encapsulated by the high-k insulator 62 (the first high-k cup 62L and the second high-k cup 62U). A layer of passivation oxide 68 (Fig. 4) is deposited by CVD, the structure is etched to form contact vias and is metalized, resulting in the structure depicted in Fig. 4.

Thus, a method and system for fabricating a ferroelectric memory transistor having long memory retention characteristics has been disclosed. It will be appreciated that further variations and modifications thereof may be made within the scope of the invention as defined in the appended claims.

As described above, a ferroelectric memory transistor according to the present invention comprises: a substrate having a source region, a gate region, and a drain region; a gate stack located on the gate region, including: a high-k insulator element, including a first high-k cup and a second high-k cup; a ferroelectric element, wherein said ferroelectric element is encapsulated within said high-k insulator element; and a top electrode located on a top portion of said high-k insulator element; a passivation oxide layer located over the substrate and gate stack; and metalizations to form respective contacts to the source region, the drain regions and the gate stack. Since the ferroelectric element is encapsulated by the high-k insulator, electrons and holes do not flow from the top electrode into the ferroelectric element. Thus, leakage current -related charge trapping, which may cause memory retention degradation, does not occur. Therefore, the memory retention characteristic of the ferroelectric memory transistor is not degraded.

**Claims**

**1.** A ferroelectric memory transistor comprising:

a substrate having a source region, a gate region, and a drain region;
a gate stack located on the gate region, including:

a high-k insulator element, including a first high-k cup and a second high-k cup;
a ferroelectric element, wherein said ferroelectric element is encapsulated within said high-k insulator element; and
a top electrode located on a top portion of said high-k insulator element;

a passivation oxide layer located over the substrate and gate stack; and
metalizations to form respective contacts to the source region, the drain regions and the gate stack.

2. The ferroelectric memory transistor of claim 1 wherein said high-k insulator element is formed of a material taken from the group of materials consisting of $HfO_2$, $ZrO_2$ and $HfZrO_X$.

3. The ferroelectric memory transistor of claim 1 wherein said high-k insulator element has a thickness of between about 2 nm to 10 nm.

4. The ferroelectric memory transistor of claim 1 wherein said ferroelectric element is formed of a material taken from the group of materials consisting of PGO, PZT, BTO, SBTO, and SBTN.

5. The ferroelectric memory transistor of claim 1 wherein said ferroelectric element has a thickness of between about 100 nm to 600 nm.

6. The ferroelectric memory transistor of claim 1 wherein said top electrode is formed of a material taken from the group of materials consisting of copper, aluminum, iridium and platinum.

7. A method of forming a ferroelectric memory transistor comprising:

a) preparing a substrate, including forming a source region, a gate region, a drain region and an oxide device isolation region;
b) depositing a sacrificial oxide layer on the substrate;
c) depositing a gate placeholder layer on the sacrificial oxide layer;
d) masking the gate placeholder layer and the sacrificial oxide layer located on the gate region and removing the gate placeholder layer and the sacrificial oxide layer on the source region, the drain region and the oxide device isolation region ;
e) depositing a layer of oxide over the structure obtained by steps a) through d) to a thickness of approximately twice that of the gate placeholder layer;
f) smoothing the structure obtained by steps a) through e) to the level of the gate placeholder layer;
g) removing the gate placeholder layer and the sacrificial oxide layer in the gate region, forming a gate placeholder structure;
h) depositing a high-k insulator layer over the structure obtained by steps a) through g) to form a first high-k cup;
i) filling the first high-k cup with a ferroelectric material to form a ferroelectric element;
j ) smoothing the ferroelectric element to the upper level of the oxide layer;
k) depositing a further high-k insulator layer on the structure obtained by steps a) through j) to form a second high-k cup over the ferroelectric element;
l) depositing a top electrode over the second high-k cup to form a gate electrode and gate stack;
m) depositing a layer of passivation oxide over the structure obtained by steps a) through l);
n) etching the passivation oxide to form respective contact vias to the source region, the drain region and the gate stack; and
o) metallizing the structure obtained by steps a) through n).

8. The method of claim 7 wherein said step g) of depositing a high-k insulating layer and depositing a first high-k cup include selecting a high-k insulator material from the group of materials consisting of $HfO_2$, $ZrO_2$ and Hf $ZrO_X$.

9. The method of claim 7 wherein said step g) of depositing a high-k insulating layer and depositing a first high-k cup includes depositing a layer of high-k materials to a thickness of between about 2 nm to 10 nm.

10. The method of claim 7 wherein said step h) of filling the first high-k cup with a ferroelectric material includes selecting a ferroelectric material from the group of materials consisting of PGO, PZT, BTO, SBTO, and SBTN.

11. The method of claim 7 wherein said step h) of filling the first high-k cup with a ferroelectric material includes filling the first high-k cup with ferroelectric material to a thickness of between about 100 nm to 600 nm.

12. The method of claim 7 wherein said step k ) of depositing a top electrode over the second high-k cup to form a gate electrode and gate stack includes selecting a top electrode material from the group of materials consisting of copper, aluminum, iridium and platinum.

13. The method of claim 7 wherein said step c ) of depositing a gate placeholder layer includes depositing a layer of material taken from the group of materials consisting of silicon nitride and polysilicon.

14. A ferroelectric memory transistor comprising:

a substrate having a source region, a gate region, and a drain region;
a gate stack located on the gate region, including:

a high-k insulator element;
a ferroelectric element encapsulated within said high-k insulator element; and
a top electrode located on a top portion of said high-k insulator element;

a passivation oxide layer located over the substrate and gate stack; and
metalizations to form respective contacts to the source region, the drain regions and the gate stack.

*FIG.1*

*FIG.2*

*FIG.3a*

*FIG.3b*

*FIG.4*

*FIG.5*

*FIG.6*

*FIG.7*

*FIG.8*

## FIG.9

## FIG.10